# EUROPEAN PATENT SPECIFICATION

(11) **EP 2 345 153 B1**
(45) Date of publication and mention of the grant of the patent: **19.09.2012**
(21) Application number: 08876282.8
(22) Date of filing: 11.11.2008
(51) Int. Cl.: H03B 19/14

(54) **A FREQUENCY GENERATOR**
FREQUENZGENERATOR
GÉNÉRATEUR DE FRÉQUENCES

(43) Date of publication of application: 20.07.2011
(73) Proprietor: Telefonaktiebolaget L M Ericsson (PUBL), 164 83 Stockholm (SE)
(72) Inventor: NYLÉN, Tomas, S-194 63 Upplands Väsby (SE)
(74) Representative: Kühn, Friedrich Heinrich
(86) International application number: PCT/SE2008/051288
(87) International publication number: WO 2010/056157

(56) References cited:
- WO-A2-01/91299
- WO-A2-2006/099071
- DE-A1- 19 946 494
- FR-A1- 2 576 470

## Description

### TECHNICAL FIELD

The present invention discloses a novel frequency generator.

### BACKGROUND

Radio receiver and transmitters such as those used in, for example, cellular communication systems, require a signal source to generate a local oscillator, LO, signal and/or a carrier signal. In order to obtain flexible solutions which can handle a wide range of frequencies, it is desired that the signal source should be able to cover a continuous and wide frequency range.

With a signal "core" source that can cover an octave, i.e. a factor two, of a certain frequency range, it is possible to generate any lower frequency by adding a selectable number of divide-by-two stages after the core source.

Traditionally, octave range frequency core generators are realized by using either a single oscillator, or by using several sub-oscillators, each of which cover a subset of the octave frequency range. However, there are some drawbacks to these solutions:
A drawback to the single oscillator approach is that the oscillator needs to cover a relatively wide (i.e. one octave) frequency range. This wide frequency range or bandwidth results in poor phase-noise performance, which in turn often leads to unacceptable system performance.

The approach with several sub-oscillators results in large, ineffective and expensive solutions. Alternative solutions which combine a generator with successive multipliers and dividers to produce a descred out put frequency are known, for example, from DE 199 46 464 Al. Further, WO 01/191 299 uses series expansions derived from selected division and side band mixing to determine a reference frequency for use in a PLL.

### SUMMARY

As has emerged from the description above, there is a need for an improved frequency generator which can cover at least an octave of a frequency range, without having the drawbacks of known solutions.

This need is addressed by the present invention in that it discloses a frequency generator which comprises an oscillator which is adapted to generate I and Q signals at a first frequency with a phase difference of 90 degrees between them.

The frequency generator also comprises a prescaler which uses the I and Q signals from the oscillator as its input signals and scales the first frequency of the input signals by a factor.

The prescaler comprises a clock phase generator which has the I and Q signals from the oscillator as its input and can generate a predetermined number of phases in the form of combinations of I and Q. In addition, the prescaler also comprises a switch bank with a number of switches. The number of switches corresponds to the number of phases which can be generated by the clock phase generator, so that each switch uses as its input one of the phases from the clock phase generator.

The prescaler also comprises a clock select logic component and a state machine which can assume a predetermined number of states as its output. The output state of the state machine is used as input to the clock select logic component in order to determine which switch in the switch bank to use as output from the switch bank and as input to the state machine, thereby determining the scaling factor of the prescaler. An output of the state machine is a signal fₒᵤₜ with a desired frequency.

In one embodiment, the predetermined number of phases in the clock phase generator is eight.

In one embodiment, the predetermined number of phases in the clock phase generator is eight.

In one embodiment, the predetermined number of states which the state machine can assume is eight.

In one embodiment, the state machine is a three-bit counter.

In one embodiment, the state machine is a Johnson-counter.

### BRIEF DESCRIPTION OF THE DRAWINGS

The invention will be described in more detail in the following, with reference to the appended drawings, in which
Fig 1 shows a first embodiment of the present invention, and
Fig 2 shows a table obtained by the invention, and
Fig 3 shows a detail of the invention, and
Fig 4 shows input/output of a part of the detail of fig 3, and
Fig 5 shows a second embodiment of the invention.

### DETAILED DESCRIPTION

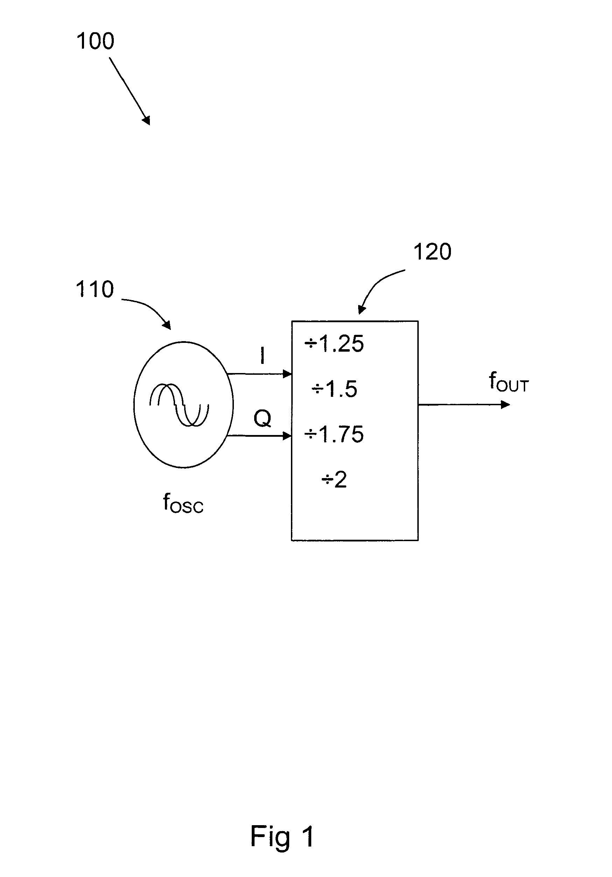

Fig 1 shows a first embodiment 100 of a frequency generator of the invention. As can be seen in fig 1, the frequency generator 100 comprises an oscillator 110, which in this embodiment is a so called quadrature oscillator, i.e. an oscillator which produces two output signals at one and the same frequency but with a phase difference of ninety degrees between them.

Due to the phase difference of ninety degrees, the two output signals are often referred to as I-and Q-signals, in-phase and quadrature phase. This is also shown in fig 1, with the output signals from the oscillator 110 being shown as I and Q.

As is also indicated in fig 1, the frequency generator 100 comprises a prescaler 120, i.e. a component which takes an input signal which is at a certain frequency and scales this frequency by a pre-determined factor. A prescaler may, for example, convert a 1 MHz signal to a 100 kHz signal, so that it scales the frequency by a factor of 10. In this case, the scaling is a division by a predetermined factor of 10, although the prescaler can also be used for "up-scaling", i.e. multiplication by a predetermined factor.

As indicated in fig 1, the prescaler 120 of the invention can be variable, so that it, in a manner which will explained in more detail later, can be used to downscale the frequency of an input signal by a variable factor, such as those shown in fig 1, i.e. 1.25, 1.5, 1.75, and 2. Naturally, other scaling factors may also be obtained using the same principles as those which will be explained below. In addition, as will be realized by those skilled in the art, the principle used by the present invention can also be used for up-scaling of the frequency from the oscillator.

In a preferred embodiment of the frequency generator 100, the oscillator 110 is also variable, so that it may, for example, be used to generate output signals at a frequency which is up to 25% above a nominal frequency f₀, i.e. the frequency of the output signal from the oscillator 110 will be in the range of 1-1.25*f₀. This variation is controlled by means of, for example, an input control signal to the oscillator, although this control signal is not shown in fig 1.

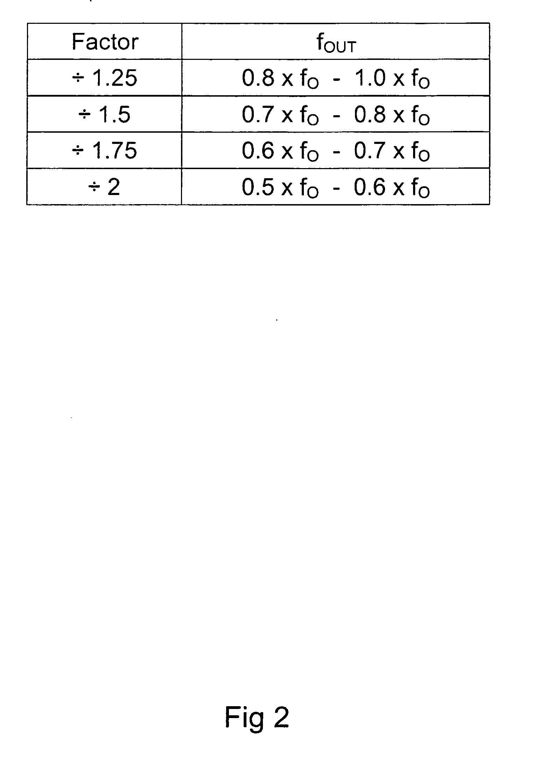

Using the factors of the examples above, the table of fig 2 shows which output frequencies, fₒᵤₜ, that may be obtained from the generator by means of the different settings in the prescaler 120. For example, using the prescaler setting of/1.25, the possible output frequencies will be in the range of 0.8 to 1.0 f₀. The exact frequency range in the modes /1.5, /1.75 and /2 is slightly larger than shown in the table of fig 2. In fig 2, the numbers are rounded off to clarify the continuous frequency coverage.

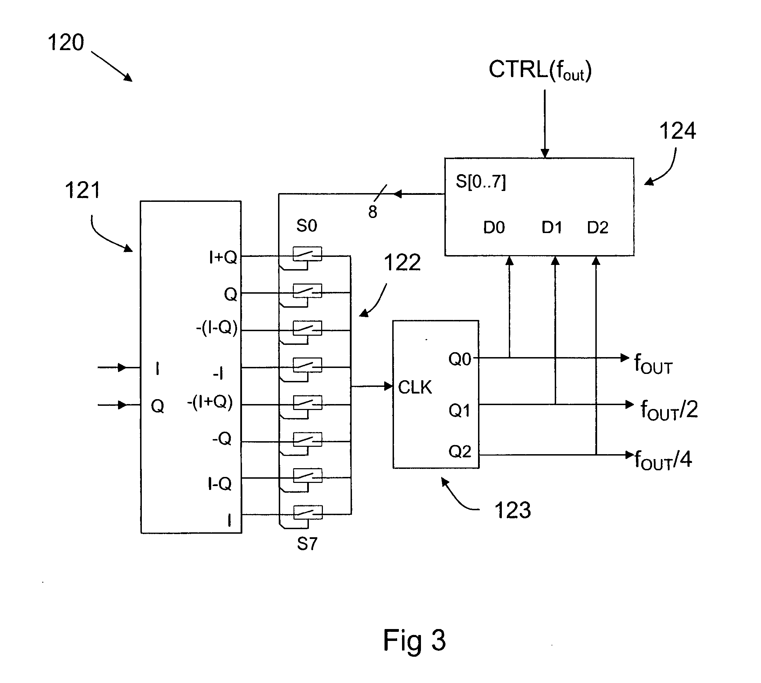

Fig 3 shows an example of a design of a prescaler 120: the prescaler 120 comprises a clock phase generator 121, a switch bank 122 of 8 switches, SO-S7, a 3-bit binary counter 123 and a clock select logic component, 124. The scaling factor of the prescaler 120 is controlled by means of a control signal to the clock select logic component, 124.

The function of the prescaler 120 is as follows: the clock phase generator 121 receives the I- and Q- signals as its input, and generates the following eight possible combinations of these signals, as indicated in fig 3:
I+Q, Q, -(I-Q), -I, -(I+Q), -Q, I-Q and I. These eight signals can also be seen as representing eight different phases or phase positions for one and the same signal in an I- and Q- coordinate system.

Based on the output state of the 3-bit counter 123, the clock select logic 124 will determine which phase signal from the component 121 that will be used next to clock the counter 123, by means of using eight output bits S0-S7 in different patterns to activate or deactivate the switches S0-S7, so that different combinations of I and Q, i.e. different phase positions, are received by the counter 123, i.e. as "clock input", CLK.

As the counter 123 is clocked, its outputs will change their states, and the clock select logic 124 will then activate the switch in the switch bank 122 that should be used next for the clock counter 123.

As indicated in fig 3, one of the three bits, Q0, of the counter 123 will deliver an output signal with the desired signal fₒᵤₜ, and the two other outputs Q1 and Q2 will deliver signals at frequencies fₒᵤₜ/2 and fₒᵤₜ/4, which may be accessed as an option.

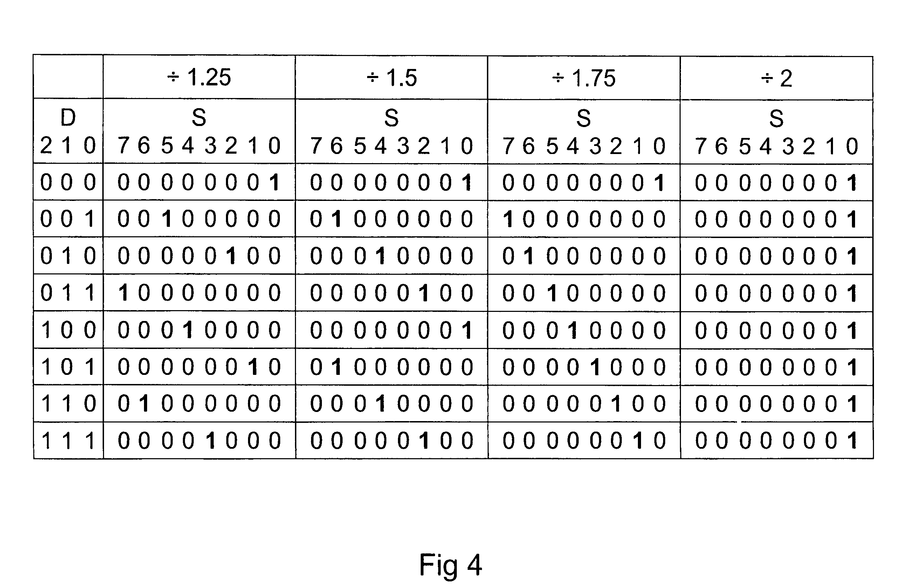

The table of fig 4 shows the output from the clock select logic 124, S0-S7, as a function of the bits at the output from the counter 123, Q0, Q1, Q2, which are also used as inputs D0, D1, D2 to the clock select logic 124. It is the output S0-S7 as a function of the input D0-D2 which is controlled by means of the control signal CTRL(fₒᵤₜ) to the circuit 124, by means of which the scaling factor of the prescaler 120 is set or varied.

Thus, the clock select logic component 124 is controlled to produce the "number" or "address" S0-S7 of a certain one of the switches in the switch bank for each input state.

In brief, the function of the prescaler is then as follows: the prescaler 120 comprises the switch bank 122 which has a number of switches, S0-S7, with the number of switches corresponding to a predetermined number of phases which can be generated by the clock phase generator 121, so that each switch S0-S7 can use as its input one of those phases.

The output from the one of the switches S0-S7 in the switch bank 122 is then used as input to the state machine 123 which can assume a predetermined number of states as its output.

The assumed state at the output of the state machine 123 is used to determine which switch S0-S7 in the switch bank 122 that will be activated and used as the output from the switch bank, and thus as the input to the state machine 123. The term "activated" is here used in the sense of being closed, i.e. the switch S0-S7 is closed so that its input signal appears as the output from the switch bank 122.

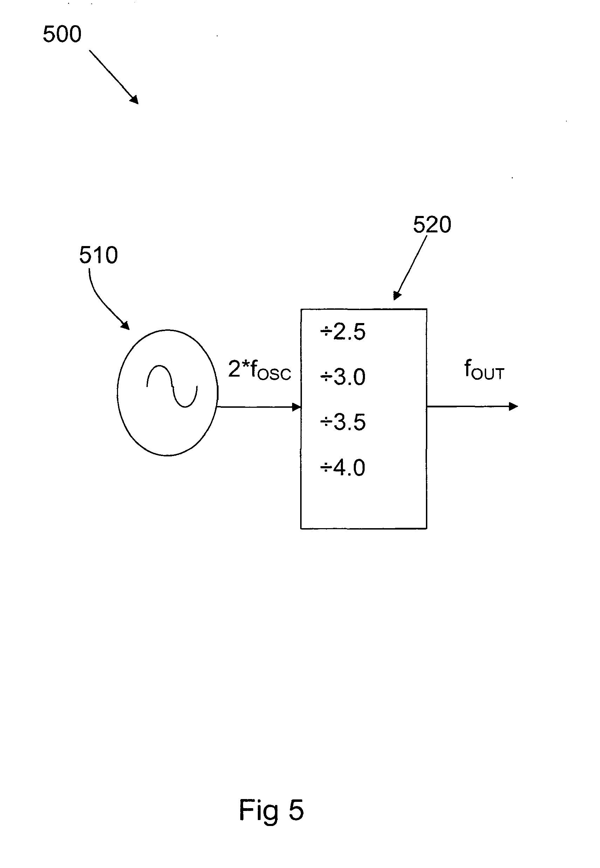

Fig 5 shows an alternative embodiment 500 of the invention. In this embodiment as swell, there is comprised an oscillator 510, which however, as opposed to the oscillator 110 of fig 1, is not a quadrature oscillator. Rather, the oscillator 510 is an oscillator which produces only one output signal. In similarity to the frequency generator 100, the frequency generator 500 comprises a prescaler 520.

If it is desired to use the embodiment 500 in order to obtain the same frequency range and bandwidth as is obtained by means of the embodiment 100 of fig 1, the oscillator 510 should be able to deliver an output signal at 2*f_{osc}, i.e. double the frequency of the I- and Q- signals of the oscillator 110 of fig 1.

In addition, in order to obtain the same results as with the frequency generator 100 of fig 1, the scaling factors of the prescaler 520 should be those shown in fig 5, i.e. 2.5, 3.0, 3.5, 4.0

The invention is not limited to the examples of embodiments described above and shown in the drawings, but may be freely varied within the scope of the appended claims. For example, the 3-bit counter 123 shown in fig 3 can be a binary counter which counts in the sequence shown in fig 4, or it can be essentially any kind of state machine with at least eight states, such as, for example a so called Johnson-counter.

With further reference to the example of a prescaler shown in fig 3, in an alternative embodiment, the clock phase generator 121 can be one which only generates ±I and ±Q, i.e. so that only four phase positions are generated. In such an embodiment, the switch bank 122 will only need to comprise four switches S0-S3, while the state machine 123 should still correspond to the one described above, i.e. a state machine which can alternate between eight different states in a predetermined manner. Thus, the number of switches in the switch bank will correspond to the number of phase positions which can be generated by the clock phase generator.

In addition, the predetermined factor by which the prescaler scales the incoming frequency can also be one, so that the input frequency is the same as the output frequency.

## Claims

1. A frequency generator (100, 500) comprising an oscillator (110, 510) which is adapted to generate I and Q signals at a first frequency with a phase difference of 90 degrees between them, the frequency generator (100, 500) also comprising a prescaler (120, 520) which uses the I and Q signal from the oscillator (110, 510) as its input signals and scales the first frequency of the Input signals by a factor, the frequency generator (100, 500) being **characterized in that** the prescaler comprises a clock phase generator (121) which has the I and Q signals from the oscillator as its input and can generate a predetermined number of phases in the form of combinations of I and Q, the prescaler also comprising a switch bank (122) with a number of switches (S0-S7), the number of switches corresponding to the number of phases which can be generated by the clock phase generator (121), so that each switch uses as its input one of the phases from the clock phase generator (121), the prescaler also comprising a clock select logic component (124) and a state machine (123) which can assume a predetermined number of states as its output, with the output state of the state machine (123) being used as input to the clock select logic component (124) to determine which switch in the switch bank (122) to use as output from the switch bank (122) and as input to the state machine (123), thereby determining the scaling factor of the prescaler, with an output of the state machine (123) being a signal fₒᵤₜ with a desired frequency.

2. The frequency generator (100) of claim 1, in which the predetermined number of phases in the clock phase generator (121) is eight.

3. The frequency generator (100) of claim 1 or 2, in which the predetermined number of phases is eight.

4. The frequency generator (100) of any of claims 1-3, in which the predetermined number of states which the state machine (123) can assume is eight.

5. The frequency generator (100) of claim 4, in which the state machine (123) is a three-bit counter (123).

6. The frequency generator (100) of claim 4, in which the state machine (123) is a Johnson-counter.

## Patentansprüche

1. Frequenzgenerator (100, 500), umfassend einen Oszillator (110, 510), der dafür eingerichtet ist, I- und Q-Signale bei einer ersten Frequenz mit einer Phasendifferenz von 90 Grad zwischen ihnen zu erzeugen, wobei der Frequenzgenerator (100, 500) außerdem einen Frequenzvorteiler (120, 520) umfasst, der die I- und Q-Signale vom Oszillator (110, 510) als seine Eingangssignale verwendet und die erste Frequenz der Eingangssignale um einen Faktor skaliert, wobei der Frequenzgenerator (100, 500) **dadurch gekennzeichnet ist, dass** der Frequenzvorteiler einen Taktphasengenerator (121) umfasst, der die I- und Q-Signale vom Oszillator als seine Eingabe hat und eine vorbestimmte Anzahl von Phasen in der Form von Kombinationen von I und Q erzeugen kann, wobei der Frequenzvorteiler außerdem eine Schalterbank (122) mit einer Anzahl von Schaltern (S0-S7) umfasst, wobei die Anzahl der Schalter der Anzahl der Phasen entspricht, die durch den Taktphasengenerator (121) erzeugt werden können, so dass jeder Schalter als seine Eingabe eine der Phasen vom Taktphasengenerator (121) verwendet, wobei der Frequenzvorteiler außerdem eine Taktwahl-Logikkomponente (124) und eine Zustandsmaschine (123), die eine vorbestimmte Anzahl von Zuständen als ihre Ausgabe annehmen kann, umfasst, wobei der Ausgangszustand der Zustandsmaschine (123) als Eingabe in die Taktwahl-Logikkomponente (124) verwendet wird, um zu bestimmen, welcher Schalter in der Schalterbank (122) als Ausgabe von der Schalterbank (122) und als Eingabe in die Zustandsmaschine (123) zu verwenden ist, wodurch der Skalierungsfaktor des Frequenzvorteilers bestimmt wird, wobei eine Ausgabe der Zustandsmaschine (123) ein Signal fₒᵤₜ mit einer erwünschten Frequenz ist.

2. Frequenzgenerator (100) nach Anspruch 1, in dem die vorbestimmte Anzahl der Phasen im Taktphasengenerator (121) acht beträgt.

3. Frequenzgenerator (100) nach Anspruch 1 oder 2, in dem die vorbestimmte Anzahl der Phasen acht beträgt.

4. Frequenzgenerator (100) nach einem der Ansprüche 1 bis 3, in dem die vorbestimmte Anzahl der Zustände, welche die Zustandsmaschine (123) annehmen kann, acht beträgt.

5. Frequenzgenerator (100) nach Anspruch 4, in dem die Zustandsmaschine (123) ein Drei-Bit-Zähler (123) ist.

6. Frequenzgenerator (100) nach Anspruch 4, in dem die Zustandsmaschine (123) ein Johnson-Zähler ist.

## Revendications

1. Générateur de fréquences (100, 500) comprenant un oscillateur (110, 510) qui est apte à générer des signaux I et Q à une première fréquence avec un déphasage de 90 degrés entre eux, le générateur de fréquences (100, 500) comprenant en outre un pré-diviseur (120, 520) lequel utilise les signaux I et Q en provenance de l'oscillateur (110, 510) en tant que ses signaux d'entrée et lequel met à l'échelle la première fréquence des signaux d'entrée par un facteur, le générateur de fréquences (100, 500) étant **caractérisé en ce que** le pré-diviseur comprend un générateur de phases d'horloge (121) qui présente les signaux I et Q en provenance de l'oscillateur en tant que ses signaux d'entrée et peut générer un nombre prédéterminé de phases, sous la forme de combinaisons des signaux I et Q, le pré-diviseur comprenant également un banc de commutateurs (122) comportant un nombre de commutateurs (S0 - S7), le nombre de commutateurs correspondant au nombre de phases pouvant être générées par le générateur de phases d'horloge (121), de sorte que chaque commutateur utilise, en tant que son entrée, l'une des phases du générateur de phases d'horloge (121), le pré-diviseur comprenant également un composant de logique de sélection d'horloge (124) et une machine à états (123) qui peut prendre un nombre prédéterminé d'états en tant que sa sortie, l'état de sortie de la machine à états (123) étant utilisé en qualité d'entrée au niveau du composant de logique de sélection d'horloge (124), en vue de déterminer quel commutateur du banc de commutateurs (122) utiliser en qualité de sortie du banc de commutateurs (122) et d'entrée vers la machine à états (123), ce qui permet de déterminer par conséquent le facteur de mise à l'échelle du pré-diviseur, une sortie de la machine à états (123) représentant un signal fₒᵤₜ avec une fréquence désirée.

2. Générateur de fréquences (100) selon la revendication 1, dans lequel le nombre prédéterminé de phases dans le générateur de phases d'horloge (121) est égal à huit.

3. Générateur de fréquences (100) selon la revendication 1 ou 2, dans lequel le nombre prédéterminé de phases est égal à huit.

4. Générateur de fréquences (100) selon l'une quelconque des revendications 1 à 3, dans lequel le nombre prédéterminé d'états que la machine à états (123) peut prendre est égal à huit.

5. Générateur de fréquences (100) selon la revendication 4, dans lequel la machine à états (123) est un compteur à trois bits (123).

6. Générateur de fréquences (100) selon la revendication 4, dans lequel la machine à états (123) est un compteur Johnson.
